(19) **Europäisches Patentamt**
**European Patent Office**
**Office européen des brevets**

(11) **EP 4 062 609 B1**

(12) **EUROPÄISCHE PATENTSCHRIFT**

(45) Veröffentlichungstag und Bekanntmachung des Hinweises auf die Patenterteilung:
**31.12.2025 Patentblatt 2026/01**

(21) Anmeldenummer: **20804214.3**

(22) Anmeldetag: **09.11.2020**

(51) Internationale Patentklassifikation (IPC):
*H04L 25/03* (2006.01)    *H04B 14/02* (2006.01)
*H03M 1/12* (2006.01)

(52) Gemeinsame Patentklassifikation (CPC):
**H04L 25/0307; H03M 1/1255; H03M 1/508; H04B 3/46; H03M 1/742; H04B 14/023; H04L 2025/03363**

(86) Internationale Anmeldenummer:
**PCT/EP2020/081443**

(87) Internationale Veröffentlichungsnummer:
**WO 2021/099154 (27.05.2021 Gazette 2021/21)**

(54) **VERFAHREN ZUM BESTIMMEN EINER INVERSEN IMPULSANTWORT EINES KOMMUNIKATIONSKANALS**

METHOD FOR DETERMINING AN INVERSE IMPULSE RESPONSE OF A COMMUNICATION CHANNEL

PROCÉDÉ DE DÉTERMINATION D'UNE RÉPONSE IMPULSIONNELLE INVERSE D'UN CANAL DE COMMUNICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.11.2019 DE 102019131217**

(43) Veröffentlichungstag der Anmeldung:
**28.09.2022 Patentblatt 2022/39**

(73) Patentinhaber: **Endress+Hauser Flowtec AG**
**4153 Reinach (CH)**

(72) Erfinder:
• **KAPPERTZ, Jannis**
**4147 Aesch (CH)**
• **STUTZ, Alexander**
**4468 Kienberg SO (CH)**

• **WUCHER, Markus**
**79541 Lörrach (DE)**

(74) Vertreter: **Endress + Hauser Group Services (Deutschland) AG+Co. KG**
**Colmarer Straße 6**
**79576 Weil am Rhein (DE)**

(56) Entgegenhaltungen:
**EP-A2- 0 936 783**

• **K. SUTHENDRAN T. ARIVOLI: "Performance Comparison of Adaptive and Blind Equalization Algorithms for Wireless Communication", BONFRING INTERNATIONAL JOURNAL OF RESEARCH IN COMMUNICATION ENGINEERING, vol. 3, no. 1, 30 March 2013 (2013-03-30), pages 01 - 06, XP055764556, ISSN: 2250-110X, DOI: 10.9756/BIJRCE.10063**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 4 062 609 B1

## Beschreibung

Die Erfindung betrifft ein Verfahren zum Bestimmen einer inversen Impulsantwort eines Kommunikationskanals mit einem mit dem Kommunikationskanal verbundenen Puls-Amplituden-Modulations-Receiver oder auch kurz PAM-Receiver.

Puls-Amplituden-Modulation ist ein bekanntes Verfahren zur Übertragung von Informationen, wobei ein Sender Informationen beispielsweise auf einem elektrischen Signal mittels PAM codiert, wobei dieses durch einen Empfänger empfangen und decodiert wird.

PAM-Signale weisen dabei mehrere Zustände in Form von verschiedenen Signalpegeln auf und können auch mehr als zwei Zustände aufweisen. So zeigen beispielsweise D.Walter und Y. Chen in "DSL Simulation Techniques and Standard Development for Digital Subscriber Line", veröffentlicht in "Macmillan Technical Publishing" 1998 einen PAM-Transceiver zur Erzeugung und Verarbeitung von PAM-Signalen.

Kommunikationskanäle wirken sich grundsätzlich negativ auf eingespeiste elektrische Signale aus, Spannungspegel bzw. Zustände eines PAM-Signals zerfallen bzw. mischen sich mit zunehmender Länge eines Kommunikationskanals. Somit muss ein empfangenes elektrisches Signal je nach Umfang einer Signalverzerrung bei einem Empfänger aufgearbeitet werden.

Zur Aufarbeitung eines verzerrten Signals ist die Kenntnis einer Inversen zu einer Impulsantwort des Kommunikationskanal nötig. Üblicherweise werden dabei zwei über den Kommunikationskanal verbundene PAM-Transceiver in ihren Frequenzen und Phasen synchronisiert. Dies kann jedoch gegebenenfalls umständlich sein. Das Dokument K. SUTHENDRAN T. ARIVOLI: "Performance Comparison of Adaptive and Blind Equalization Algorithms for Wireless Communication", 2013-03-30 offenbart ein Verfahren zum Bestimmen einer inversen Impulsantwort eines Kommunikationskanals mit einem mit dem Kommunikationskanal verbundenen PAM-Receiver umfassend ein adaptives Filter.

Aufgabe der Erfindung ist es daher, ein robustes Verfahren zur Bestimmung einer Inversen einer Impulsantwort eines Kommunikationskanals zu bestimmen, welcher Kommunikationskanal einen zu einem PAM-Transmitter asynchronen PAM-Receiver verbindet.

Die Aufgabe wird gelöst durch ein Verfahren gemäß dem unabhängigen Anspruch 1.

Bei einem erfindungsgemäßen Verfahren zum Bestimmen einer inversen Impulsantwort eines Kommunikationskanals mit einem mit dem Kommunikationskanal verbundenen PAM-Receiver umfassend ein adaptives Filter, wobei der Kommunikationskanal zwecks Kommunikation mit einem PAM-Transmitter mittels eines elektrischen Datensignals mit mindestens zwei Zuständen, und insbesondere mindestens drei Zuständen eingerichtet ist,

wobei die Zustände insbesondere jeweils ein Symbol repräsentieren, wobei jedem Takt des Datensignals ein Symbol des Datensignals zugeordnet ist,

wobei der PAM-Receiver eine elektronische Schaltung aufweist, welche folgendes umfasst:

Eine Datenschnittstelle eingerichtet zur Verbindung mit dem Kommunikationskanal, insbesondere einem Duplex-Kommunikationskanal;

Einen Schaltungsabschnitt verbunden mit der Datenschnittstelle umfassend:

- Einen Entzerrer zur Kompensation von Störungen des Digitalsignals, welche durch den Kommunikationskanal verursacht werden, wobei der Entzerrer einen ersten Eingang zur Aufnahme des Datensignals aufweist, und wobei der Entzerrer einen Ausgang zum Ausgeben eines bearbeiteten Datensignals aufweist;
- Einen nach dem Entzerrer angeordneten Interpretierer zur Erkennung von Symbolen, welche durch das Digitalsignal übertragen werden, wobei der Interpretierer das bearbeitete Datensignal aufnimmt;

umfasst das Verfahren folgende Verfahrensschritte:

Einschalten des PAM-Receivers einem ersten Verfahrensschritt;

Bei eingeschaltetem PAM-Transmitter Einstellen eines Unterschieds zwischen einer Taktfrequenz des Datensignals und einer Abtastfrequenz des PAM-Receivers in einem zweiten Verfahrensschritt;

Vergleichen eines durch den Interpretierer ausgegebenen Symbols mit einem dem Interpretierer zugeführten Zustand und Ausgeben eines Fehlerwerts in einem dritten Verfahrensschritt, wobei jeweils ein zu einem Abtasttakt gehörendes Symbol mit einem zum selben Abtasttakt gehörenden Zustand verglichen wird;

Anpassen von m Filterkoeffizienten des Entzerrers zur Minimierung von Fehlerwerten in einem vierten Verfahrensschritt mit m als natürliche Zahl;

Wiederholen des dritten Verfahrensschritts und des vierten Verfahrensschritts, bis ein Fehlergrenzwert erreicht ist;

wobei falls eine Konvergenz von Filterkoeffizienten gegen 0 stattfindet, der Unterschied größer gewählt und der dritte Verfahrensschritt sowie der vierte Verfahrensschritt wiederholt, bis eine Konvergenz gegen Filterkoeffizienten stattfindet.

Eine ausreichende Konvergenz kann beispielsweise durch Auswerten von Unterschieden von berechneten Filterkoeffizienten aufeinanderfolgender Iterationen festgestellt werden. Beispielsweise kann eine Unterschreitung eines Unterschiedshöchstwerts ein Kriterium für eine ausreichende Konvergenz sein.

Eine Plausibiliät der Filterkoeffizienten kann beispielsweise durch Vergleich mit einer Abschätzung von erwarteten Filterkoeffizienten überprüft werden. Bei ungefähr bekannter Kabellänge und/oder bei bekannter Kabeltechnologie kann durch physikalisch-technisches Abschätzen ein Erwartungswert für Filterkoeffizienten angegeben werden.

In einer Ausgestaltung werden Filterkoeffizienten mit jedem nachfolgenden Takt n+1 auf folgende Weise berechnet:

$$FK(n+1) = FK(n) + AK*E(n)*DK(n),$$

mit AK als Anpassungskoeffizient,

wobei FK eine Liste ist mit m Einträgen,

und wobei DK eine Liste der letzten m Zustände des Datensignals ist.

In einer Ausgestaltung wird das Vergleichen durch eine Subtrahierschaltung mit zwei Eingängen und einem Ausgang durchgeführt, wobei der Ausgang der Subtrahierschaltung dem Entzerrer zwecks Anpassung der Filterkoeffizienten einem Eingang des Entzerrers zugeführt ist, und wobei der Subtrahierschaltung ein durch den Entzerrer ausgegebener Zustand sowie ein durch den Interpretierer ausgegebenes Symbol zugeführt werden,
oder wobei der Entzerrer eine Subtrahierschaltung aufweist, wobei der Subtrahierschaltung über einen zweiten Eingang des Entzerrers das durch den Interpretierer ausgegebene Symbol zugeführt wird.

In einer Ausgestaltung basiert das Anpassen der Filterkoeffizienten auf einer Minimierung von Fehlerquadraten, bzw. auf einem "Least-Mean-Squares"-Verfahren.

Im Folgenden wird die Erfindung anhand von Ausführungsbeispielen beschrieben.

Fig. 1 beschreibt ein beispielhaftes PAM-Signal;
Fig. 2 skizziert einen Ausschnitt eines PAM-Receivers;
Fig. 3 beschreibt den beispielhaften Ablauf eines erfindungsgemäßen Verfahrens.

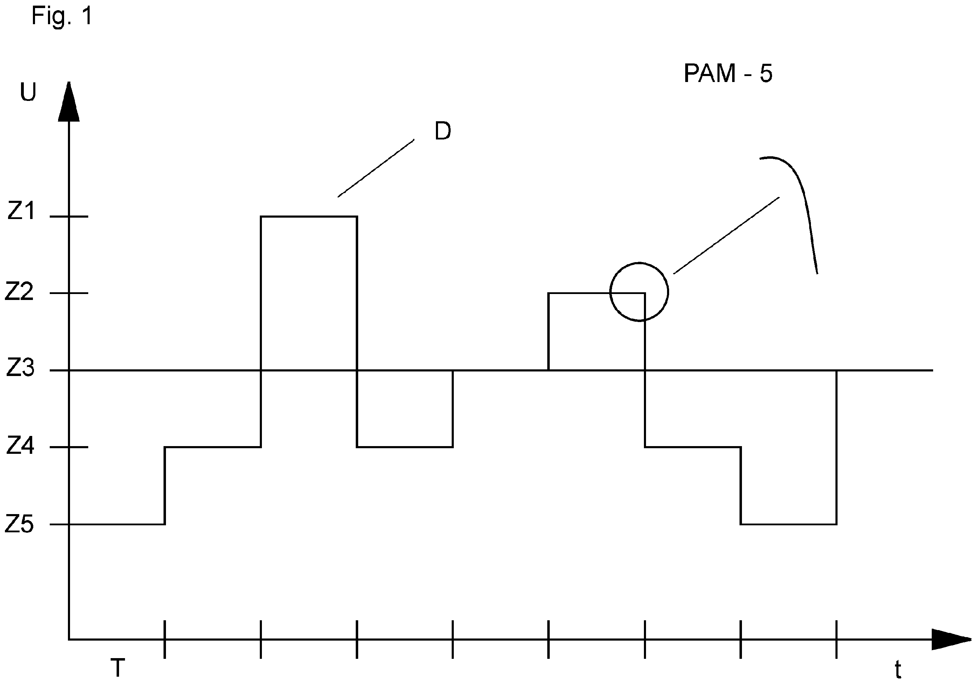

Fig. 1 skizziert ein beispielhaftes amplitudenmoduliertes Datensignal D, ein PAM-5-Signal mit 5 Zuständen Z1 bis Z5. Jeder Zustand weist eine Zeitdauer auf, welche einem Takt T des Datensignals D entspricht. Durch Einrichten von mehr als zwei Zuständen ist die Informationsdichte des Datensignals erhöht. Jedoch erleidet das Datensignal aufgrund von Störeinflüssen einen Zustandszerfall, welcher sich in einem Anfangsstadium wie angedeutet durch ein Abrunden von Signalkanten ausdrückt. In fortgeschrittenem Stadium führt der Zustandszerfall zu einem Ineinanderlaufen und Mischen von benachbarten Zuständen. Bei Kenntnis der Kanalimpulsantwort des Kanals kann der Zerfall zumindest teilweise kompensiert, bzw. das Datensignal weitgehend aufgearbeitet werden. PAM-Signale sind jedoch nicht auf 5 Zustände beschränkt, sondern können generell zwei oder mehr Zustände bzw. Signalpegel aufweisen.

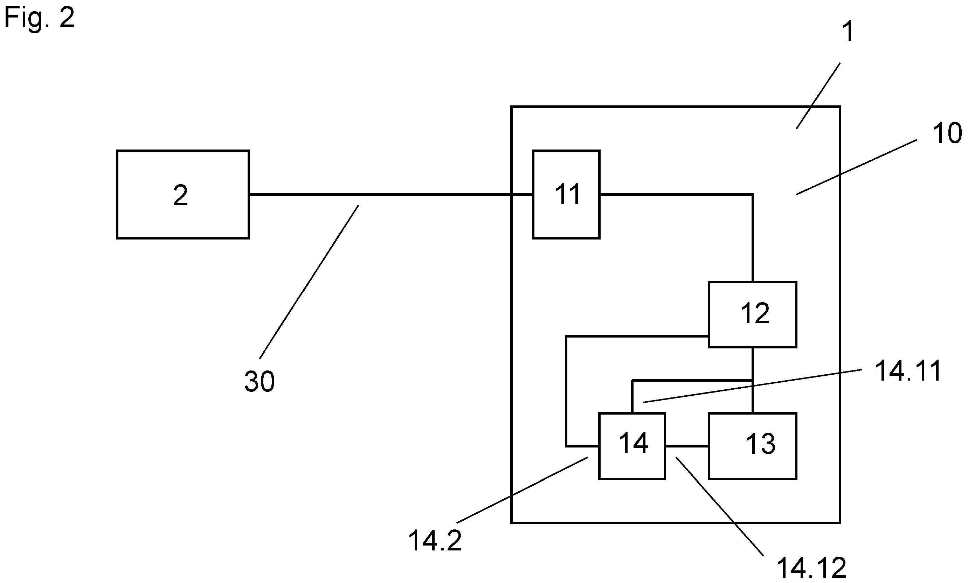

Fig. 2 skizziert einen PAM-Receiver 1 und einen PAM-Transmitter 2, welche über einen Kommunikationskanal 30 in Verbindung stehen. Der PAM-Receiver, mittels welchem erfindungsgemäß eine Inverse der Impulsantwort des Kommunikationskanals bestimmt wird, weist eine elektronische Schaltung 10 mit einer mit dem Kommunikationskanal verbundenen Datenschnittstelle 11, einem Entzerrer 12, einem Interpretierer 13 sowie einer Subtrahierschaltung 14 mit zwei Eingängen 14.11 und 14.12 sowie einem Ausgang 14.2. Die elektronische Schaltung 10 weist weitere, hier nicht gezeigte elektronische Bauteile auf, welche für die Erfindung nicht von Belang sind. PAM-Signale, wie in Fig. 1 beispielhaft skizziert, weisen mehrere Zustände auf, welche mit verschiedenen Signalpegeln korrespondieren. Bei Durchlaufen eines Kommunikationskanals erfahren diese Zustände Verzerrungen, die beispielsweise durch Störkapazitäten und/oder Störinduktivitäten des Kommunikationskanals verursacht sind. Solche Verzerrungen, bzw. Zustandszerfälle können jedoch zumindest teilweise rückgerechnet werden, sofern diese Störeinflüsse bekannt sind. Die Kenntnis dieser Störeinflüsse drückt sich in der Kenntnis der Inversen der Impulsantwort aus. Die Datenschnittstelle 11 erfasst das eingehende PAM-Signal bzw. Datensignal und digitalisiert es mittels eines Analog-/Digitalwandlers (nicht gezeigt), wobei das digitalisierte PAM-Signal dem Entzerrer 12 zugeführt wird. Das durch den Entzerrer zumindest teilweise entzerrte Datensignal wird an einen Interpretierer 13 weitergeleitet, welcher den Zuständen des Datensignals Symbole zuordnet. Die Zuweisung der Symbole richtet sich nach digitalen Werten von Spannungen bzw. Signalpegel der eingehenden Zustände. Der Entzerrer weist dabei ein adaptives Filter auf, welches Filter die eigenen Filterkoeffizienten so einstellt, dass durch den Interpretierer ausgegebene Symbole zu an den Interpretierer übermittelte Zustände passen. Das adaptive Filter kann beispielsweise das Datensignal zeitverzögert mit sich selbst mischen. In diesem Fall betreffen Filterkoeffizienten beispielsweise eine Anzahl von Mischungen, Mischungsstärke, und zeitliche Verschiebung der Mischungen.

Eine Subtrahierschaltung 14 vergleicht dabei durch den Interpretierer ausgegebene Symbole mit an den Interpretierer übermittelte Zuständen und leitet ein Ergebnis des Vergleichs an den Entzerrer weiter. Dieses Ergebnis wird vom Entzerrer genutzt, Filterkoeffizienten anzupassen, um eine Zuordnung "Zustand - Symbol" zu verbessern. Falls beispielsweise bei PAM-2 zu Beginn der Einstellung der Filterkoeffizienten die Zuordnung "Zustand - Symbol" in deutlich mehr als die Hälfte aller empfangenen Zustände korrekt funktioniert, findet eine Konvergenz der Filterkoeffizienten gegen jeweilige Grenzwerte statt. Die Konvergenz kann beispielsweise als abgeschlossen definiert werden, wenn das von der Subtrahierschaltung ausgegebene Ergebnis einen Fehlergrenzwert FG unterschreitet. Das Unterschreiten des Fehlergrenzwert kann ein Unterschreiten des Fehlergrenzwerts durch einen Mittelwert von Differenzen mehrerer Takte sein. Der Vergleich basiert auf einer Auswertung eines Unterschieds bzw. Differenz zwischen einem digitalen Wert eines Zustands und einem digitalen Wert eines Symbols.

Nach Konvergenz der Filterkoeffizienten ist die Kenntnis über die Inverse in den Filterkoeffizienten gespeichert. Im Stand der Technik findet dieser Prozess bei zum PAM-Transmitter 2 synchronisiertem PAM-Receiver 1 statt. Synchron bedeutet in diesem Zusammenhang, dass eine Abtastfrequenz des Datensignals durch den PAM-Receiver einer Taktfrequenz des Datensignals D entspricht und Abtastpunkte mit Signalpegeln und nicht mit Signalflanken korrelieren. Eine leichte Asynchronität muss unbedingt vermieden werden, da in diesem Fall Abtastpunkte zum Datensignal mit jedem Takt leicht verschoben werden und damit unweigerlich mit Taktflanken und insbesondere mit Nulldurchgängen einer Spannung des Datensignals korrelieren. In diesem Fall findet eine Konvergenz der Filterkoeffizienten gegen Grenzwerte statt, die nicht der Inversen der Kanalimpulsantwort entsprechen. Solche Grenzwerte können beispielsweise jeweils eine Null sein.

Kern der Erfindung ist es, eine Mindestasynchronität einzurichten, mit welcher sichergestellt ist, dass Abtastpunkte nur wenige Male hintereinander in einen Bereich einer Taktflanke bzw. eines Nulldurchgangs einer Spannung fallen. Auf diese Weise findet eine Mittelung zwischen Abtastpunkten, welche mit Signalpegeln und Abtastpunkten, welche mit Signalflanken bzw. Nulldurchgängen korrelieren statt. Es hat sich gezeigt, dass in diesem Fall eine Konvergenz von Filterkoeffizienten gegen Grenzwerte stattfindet, welche mit der Inversen der Impulsantwort des Kommunikationskanals korrespondieren.

Die Mindestasynchronität kann beispielsweise durch Ausprobieren eingerichtet werden. Falls eine Konvergenz von Filterkoeffizienten gegen 0 oder einen anderen Grenzwert, der nicht mit der Inversen korrespondiert stattfindet, dann wird ein Unterschied UF zwischen einer Abtastfrequenz und der Taktfrequenz des Datensignals sukzessive größer gewählt, bis eine Konvergenz gegen sinnvolle bzw. plausible Grenzwerte stattfindet.

Es kann auch eine Mindestasynchronität durch folgende Gleichung: UF / AK > G festgelegt werden mit AK als Anpassungskoeffizient zur Festlegung einer iterativen Anpassungsgeschwindigkeit der Filterkoeffizienten und G einem Grenzwert.

Filterkoeffizienten FK werden mit jedem nachfolgenden Takt n+1 beispielsweise auf folgende Weise berechnet:

$$FK(n+1) = FK(n) + AK*E(n)*DK(n),$$

wobei FK eine Liste ist mit m Einträgen, und wobei DK beispielsweise eine Liste ist der letzten m Zustände des Datensignals D ist.

In einer Ausgestaltung kann der PAM-Receiver 1 auch Datensignale senden und somit ein PAM-Transceiver sein.

In einer Ausgestaltung kann der PAM-Transmitter 2 auch Datensignale empfangen und somit ein PAM-Transceiver sein.

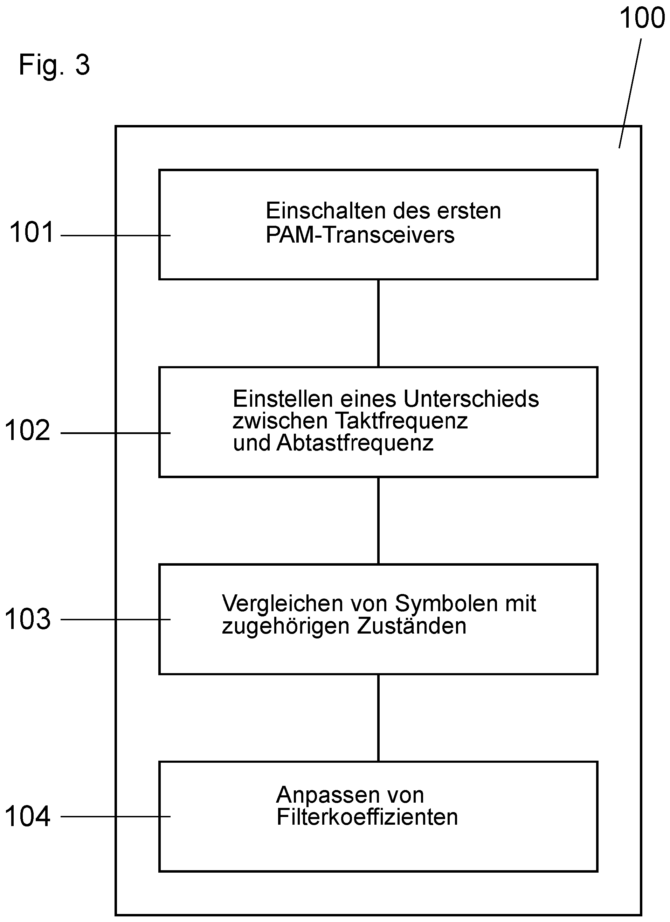

Fig. 3 veranschaulicht den Ablauf eines erfindungsgemäßen Verfahrens 100, wobei in einem ersten Verfahrensschritt 101 der PAM-Receiver angeschaltet wird. In einem zweiten Verfahrensschritt 102 wird ein Mindestunterschied U zwischen Taktfrequenz des Datensignals D sowie der Abtastfrequenz sichergestellt. In einem dritten Verfahrensschritt 103 werden durch die Subtrahierschaltung 14 durch den Interpretierer ausgegebene Symbole mit an den Interpretierer übermittelten Zuständen verglichen und eine Differenz wird an den Entzerrer weitergeleitet. In einem vierten Verfahrensschritt 104 werden Filterkoeffizienten des Entzerrers angepasst, um die Differenz zu minimieren. Die Minimierung der Differenzen kann dabei auf einer Minimierung von Fehlerquadraten basieren. In einer Ausgestaltung kann der PAM-Receiver 1 auch Datensignale senden und somit ein PAM-Transceiver sein. In einer Ausgestaltung kann der PAM-Transmitter 2 auch Datensignale empfangen und somit ein PAM-Transceiver sein.

**Patentansprüche**

1. Verfahren (100) zum Bestimmen einer inversen Impulsantwort eines Kommunikationskanals (30) mit einem mit dem Kommunikationskanal verbundenen PAM-Receiver (1) umfassend ein adaptives Filter, wobei der Kommunikationskanal zwecks Kommunikation mit einem PAM-Transmitter (2) mittels eines elektrischen Datensignals (D) mit mindestens zwei Zuständen (Z), und insbesondere mindestens drei Zuständen eingerichtet ist,

   wobei die Zustände insbesondere jeweils ein Symbol repräsentieren, wobei jedem Takt (T) des Datensignals ein Symbol (S) zugeordnet ist,

wobei der PAM-Receiver eine elektronische Schaltung (10) aufweist, welche folgendes umfasst:

Eine Datenschnittstelle (11) eingerichtet zur Verbindung mit dem Kommunikationskanal, insbesondere einem Duplex-Kommunikationskanal;

Einen Schaltungsabschnitt verbunden mit der Datenschnittstelle umfassend:

- Einen Entzerrer (12) zur Kompensation von Störungen des Digitalsignals, welche durch den Kommunikationskanal verursacht werden, wobei der Entzerrer einen ersten Eingang zur Aufnahme des Datensignals (D) aufweist, und wobei der Entzerrer einen Ausgang zum Ausgeben eines bearbeiteten Datensignals aufweist;

- Einen nach dem Entzerrer angeordneten Interpretierer (13) zur Erkennung von Symbolen, welche durch das Digitalsignal übertragen werden, wobei der Interpretierer das bearbeitete Datensignal aufnimmt;

wobei das Verfahren folgende Verfahrensschritte umfasst:

Einschalten des PAM-Receivers in einem ersten Verfahrensschritt (101);

Bei eingeschaltetem PAM-Transmitter Einstellen eines Unterschieds (UF) zwischen einer Taktfrequenz des Datensignals und einer Abtastfrequenz des PAM-Receivers in einem zweiten Verfahrensschritt (102);

Vergleichen eines durch den Interpretierer ausgegebenen Symbols (S) mit einem dem Interpretierer zugeführten Zustand (Z) und Ausgeben eines Fehlerwerts (E) in einem dritten Verfahrensschritt (103), wobei jeweils ein zu einem Abtasttakt gehörendes Symbol mit einem zum selben Abtasttakt gehörenden Zustand verglichen wird;

Anpassen von m Filterkoeffizienten (FK) des Entzerrers zur Minimierung von Fehlerwerten in einem vierten Verfahrensschritt (104) mit m als natürliche Zahl;

Wiederholen des dritten Verfahrensschritts und des vierten Verfahrensschritts, bis ein Fehlergrenzwert (FG) erreicht ist,

wobei falls eine Konvergenz von Filterkoeffizienten gegen 0 stattfindet, UF größer gewählt und der dritte Verfahrensschritt sowie der vierte Verfahrensschritt wiederholt werden, bis eine Konvergenz gegen Filterkoeffizienten stattfindet.

2. Verfahren nach Anspruch 1,

wobei Filterkoeffizienten (FK) mit jedem nachfolgenden Takt n+1 auf folgende Weise berechnet werden:

$$FK(n+1) = FK(n) + AK*E(n)*DK(n),$$

mit AK als Anpassungskoeffizient,
wobei FK eine Liste ist mit m Einträgen,
und wobei DK eine Liste ist der letzten m Zustände des Datensignals D ist.

3. Verfahren nach einem der vorigen Ansprüche,

wobei das Vergleichen durch eine Subtrahierschaltung (14) mit zwei Eingängen (14.11, 14.12) und einem Ausgang (14.2) durchgeführt wird, wobei der Ausgang der Subtrahierschaltung dem Entzerrer zwecks Anpassung der Filterkoeffizienten einem Eingang des Entzerrers zugeführt ist, und wobei der Subtrahierschaltung ein durch den Entzerrer ausgegebenen Zustand sowie ein durch den Interpretierer ausgegebenes Symbol zugeführt werden,
oder wobei der Entzerrer eine Subtrahierschaltung aufweist, wobei der Subtrahierschaltung über einen zweiten Eingang des Entzerrers das durch den Interpretierer ausgegebene Symbol zugeführt wird.

4. Verfahren nach einem der vorigen Ansprüche, wobei das Anpassen der Filterkoeffizienten auf einer Minimierung von Fehlerquadraten basiert.

**Claims**

1. Method (100) for determining an inverse impulse response of a communication channel (30) with a PAM receiver (1) connected to the communication channel, comprising an adaptive filter,

wherein the communication channel is configured for communication with a PAM transmitter (2) via an electrical data signal (D) with at least two states (Z), and in particular at least three states,
wherein the states each represent a symbol, and each clock cycle (T) of the data signal is assigned a symbol (S),

wherein the PAM receiver comprises an electronic circuit (10), which includes:

• A data interface (11) configured to connect to the communication channel, in particular a duplex communication channel;
• A circuit section connected to the data interface comprising:

◦ An equalizer (12) for compensating disturbances of the digital signal caused by the communication channel, wherein the equalizer has a first input for receiving the data signal (D), and an output for outputting a processed data signal;
◦ An interpreter (13) arranged downstream of the equalizer for detecting symbols transmitted by the digital signal, wherein the interpreter receives the processed data signal;

wherein the method comprises the following steps:

• Switching on the PAM receiver in a first method step (101);
• In a second method step (102), with the PAM transmitter switched on, setting a difference (UF) between a clock frequency of the data signal and a sampling frequency of the PAM receiver;
• Comparing a symbol (S) output by the interpreter with a state (Z) supplied to the interpreter and outputting an error value (E) in a third method step (103), wherein a symbol belonging to a sampling clock is compared with a state belonging to the same sampling clock;
• Adjusting m filter coefficients (FK) of the equalizer to minimize error values in a fourth method step (104), with m being a natural number;
• Repeating the third and fourth method steps until an error threshold (FG) is reached, wherein, if convergence of the filter coefficients towards zero occurs, UF is increased and the third and fourth method steps are repeated until convergence towards filter coefficients occurs.

2. Method according to claim 1,

wherein filter coefficients (FK) are calculated for each subsequent clock cycle n+1 as follows:

$$FK(n+1) = FK(n) + AK \times E(n) \times DK(n),$$

with AK as an adaptation coefficient,

wherein FK is a list with m entries, and DK is a list of the last m states of the data signal D.

3. Method according to any of the preceding claims,

wherein the comparison is performed by a subtraction circuit (14) with two inputs (14.11, 14.12) and one output (14.2), wherein the output of the subtraction circuit is supplied to the equalizer for adjusting the filter coefficients, and wherein the subtraction circuit receives a state output by the equalizer and a symbol output by the interpreter, or wherein the equalizer comprises a subtraction circuit, and the symbol output by the interpreter is supplied to the subtraction circuit via a second input of the equalizer.

4. Method according to any of the preceding claims, wherein the adjustment of the filter coefficients is based on minimizing squared errors.

**Revendications**

1. Procédé (100) de détermination d'une réponse impulsionnelle inverse d'un canal de communication (30) avec un récepteur PAM (1) connecté au canal de communication, comprenant un filtre adaptatif,

le canal de communication étant configuré pour communiquer avec un émetteur PAM (2) via un signal de données électrique (D) ayant au moins deux états (Z), et en particulier au moins trois états, les états représentant chacun un symbole, chaque cycle d'horloge (T) du signal de données étant associé à un symbole (S), le récepteur PAM comprenant un circuit électronique (10), lequel comprend :

• Une interface de données (11) conçue pour être connectée au canal de communication, notamment un canal de communication duplex ;
• Une section de circuit connectée à l'interface de données comprenant :

◦ Un égaliseur (12) destiné à compenser les perturbations du signal numérique causées par le canal de communication, l'égaliseur ayant une première entrée pour recevoir le signal de données (D) et une sortie pour délivrer un signal de données traité ;
◦ Un interpréteur (13) disposé après l'égaliseur pour détecter les symboles transmis par le signal numérique, l'interpréteur recevant le signal de données traité ;

le procédé comprenant les étapes suivantes :

• Mise en marche du récepteur PAM dans une première étape (101) ;
• Dans une deuxième étape (102), avec l'émetteur PAM activé, réglage d'une différence (UF) entre la fréquence d'horloge du signal de données et la fréquence d'échantillonnage du récepteur PAM ;
• Comparaison d'un symbole (S) délivré par l'interpréteur avec un état (Z) fourni à l'interpréteur et émission d'une valeur d'erreur (E) dans une troisième étape (103), un symbole appartenant à un cycle d'échantillonnage étant comparé à un état appartenant au même cycle ;
• Ajustement de m coefficients de filtre (FK) de l'égaliseur pour minimiser les valeurs d'erreur dans une quatrième étape (104), m étant un nombre naturel;
• Répétition des troisième et quatrième étapes jusqu'à ce qu'une valeur limite d'erreur (FG) soit atteinte,

si une convergence des coefficients de filtre vers zéro se produit, UF est augmenté et les troisième et quatrième étapes sont répétées jusqu'à ce qu'une convergence vers des coefficients de filtre se produise.

2. Procédé selon la revendication 1,

les coefficients de filtre (FK) étant calculés à chaque cycle d'horloge suivant n+1 comme suit :

$$FK(n+1) = FK(n) + AK \times E(n) \times DK(n),$$

avec AK comme coefficient d'adaptation,
FK étant une liste de m éléments,
et DK étant une liste des m derniers états du signal de données D.

3. Procédé selon l'une des revendications précédentes,

la comparaison étant effectuée par un circuit soustracteur (14) avec deux entrées (14.11, 14.12) et une sortie (14.2),
la sortie du circuit soustracteur étant transmise à l'égaliseur pour l'ajustement des coefficients de filtre,
le circuit soustracteur recevant un état délivré par l'égaliseur et un symbole délivré par l'interpréteur,
ou l'égaliseur comprenant un circuit soustracteur, le symbole délivré par l'interpréteur étant transmis au circuit soustracteur via une seconde entrée de l'égaliseur.

4. Procédé selon l'une des revendications précédentes,
l'ajustement des coefficients de filtre étant basé sur la minimisation des carrés des erreurs.

Fig. 1

PAM - 5

Fig. 2

Fig. 3

100

101 — Einschalten des ersten
PAM-Transceivers

102 — Einstellen eines Unterschieds
zwischen Taktfrequenz
und Abtastfrequenz

103 — Vergleichen von Symbolen mit
zugehörigen Zuständen

104 — Anpassen von
Filterkoeffizienten

# EP 4 062 609 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **D.WALTER** ; **Y. CHEN**. DSL Simulation Techniques and Standard Development for Digital Subscriber Line. Macmillan Technical Publishing, 1998

- **K. SUTHENDRAN** ; **T. ARIVOLI**. *Performance Comparison of Adaptive and Blind Equalization Algorithms for Wireless Communication*, 30 March 2013

11